Europäisches Patentamt

European Patent Office

Office européen des brevets

(11) Publication number: 0 312 217
A1

# EUROPEAN PATENT APPLICATION

(21) Application number: 88308865.0

(22) Date of filing: 23.09.88

(51) Int. Cl.4: H01L 21/60 , H01L 23/14 , H01L 29/06

(30) Priority: 30.09.87 US 102977

(43) Date of publication of application:
19.04.89 Bulletin 89/16

(84) Designated Contracting States:
DE ES FR GB IT NL

(71) Applicant: AMERICAN TELEPHONE AND
TELEGRAPH COMPANY
550 Madison Avenue
New York, NY 10022(US)

(72) Inventor: Pfeiffer, Loren Neil
Red Gate Road
Morristown New Jersey 07960(US)
Inventor: Wong, Yiu-Huen
160 Woodland Avenue
Summit New Jersey 07901(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Integrated circuit chip assembly.

(57) Integrated circuit chips (11) are attached, and electrically connected across a desired distance, to a substrate (31) in a facing relationship; electrical interconnection typically involves solder connections (52) between facing contact pads. Positive control of the desired distance is achieved by chip and/or substrate surface spacer features such as, e.g., miniature pyramids (33) - optionally in combination with matching opposite features. Conveniently, in the case of silicon chips on a silicon substrate, as well as in the case of analogous Group III-V compound semiconductor structures, surface spacer features are produced by orientation dependent chemical etching.

FIG. 5

## INTEGRATED CIRCUIT CHIP ASSEMBLY

### Technical Field

The invention is concerned with compact assemblies of integrated circuit chips on a substrate.

### Background of the Invention

In the interest of processing speed as well as of storage capacity, physical compactness is a key aspect in the design of advanced computing data processing, and telecommunications switching systems. Compactness in turn depends on a variety of designs features such as, e.g., miniaturization of circuitry and integrated components on integrated circuit chips, as well as how chips are interconnected and combined into subassemblies and assemblies.

While initially it was general practice to mount chips in frames which then were combined into larger assemblies, alternate designs have been considered as disclosed, e.g, in

P. Kraynak et. al., "Wafer-Chip Assembly for Large-Scale Integration", *IEEE Transactions on Electron Devices*, Vol. ED-15 (1968), pp. 660-663 where silicon chips are shown as connected to a silicone substrate;

L. F. Miller, "Controlled Collapse Reflow Chip Joining", *IBM Journal of Research and Development* Vol. 13 (1969), pp. 239-250 where silicon chips are shown as attached to a ceramic substrate or "module";

R. F. Bonner et al., "Advanced Printed-circuit Board Design for High-performance Computer Applications", *IBM Journal of Research and Development*, Vol. 26 (1982), pp. 297-305 where circuit boards are disclosed as suitable for insertion of a number of substrate modules;

C. W. Ho et al., "The Thin-film Module as a High-performance Semiconductor Package", *IBM Journal of Research and Development*, Vol. 26 (1982), pp. 286-296, disclosing power supply stabilization on a ceramic substrate by means of an integrated decoupling capacitor; and

U. S. patent 4,670,770, "Integrated Circuit Chip-and-Substrate Assembly", issued June 2, 1987 to K. L. Tai, disclosing the assembly of single-crystal chips on a single-crystal substrate including a particularly advantageous integrated decoupling capacitor arrangement, as well as alignment of chips on a substrate as facilitated by anisotropically etched surface features.

Attention in the following will be directed primarily to chip assemblies on substrates such as, e.g., assemblies of silicon chips on a silicon wafer, and attention will be directed to particularly advantageous alignment structures.

### Summary of the Invention

Integrated circuit chips are placed on a substrate, with a chip surface spaced by a desired distance from a surface of the substrate. Positive distance control results upon bringing a chip- or substrate-surface feature in physical contact with the facing substrate or chip surface. Among suitable surface features are miniature pyramids on the substrate or on the chips, and such features may be combined, in the interest of lateral chip alignment, with corresponding surface features on the facing chip or substrate surface, respectively.

On account of distance control in accordance with the invention, solder interconnection of circuitry on chips and on the substrate by so-called reflow soldering is facilitated in that upon heating, "solder bumps" are merged into solder bridges having optimized cross section. Contemplated also are chips including optically sensitive or active features such as, e.g., radiation detectors, lasers, and modulators, as well as passive micro-optic components.

The invention is applicable to silicon-on-silicon technology as well as, e.g., to Group III-V material systems where, conveniently, preferred surface features can be made by orientation-dependent chemical etching. Other fabrication methods, applicable whether or not substrate and chip materials are in single-crystal form, may involve the use of selective ablation, e.g., by reactive ion etching, ion milling, or photochemical etching.

### Brief Description of the Drawing

FIG. 1 is a schematic face-on view of an integrated circuit chip having etched alignment features in accordance with a preferred embodiment of the invention;

FIG. 2 is a schematic cross-sectional view of the chip of FIG. 1;

FIG. 3 is a schematic face-on view of a carrier substrate having alignment features in accordance with a preferred embodiment of the invention;

FIG. 4 is a schematic cross-sectional view of the carrier substrate of FIG. 3; and

FIG. 5 is a schematic cross-sectional view of a substrate-chip assembly obtained upon matching chips in accordance with FIG. 1 and 2 to a substrate in accordance with with FIG. 3 and 4.

## Detailed Description

Terms defined as follows are used prominently in the description of the invention;

A *substrate* is a material body which has a surface which can serve as a support for material objects which may be insufficiently rigid in the absence of support or whose spatial arrangement depends on the presence of a support. A substrate may consist of a single material such as, e.g., silicon, or else of several materials as, e.g., in the case of silicon-on-insulator technology. Substrate materials may have a single-crystal, polycrystalline, glassy, or amorphous structure.

A *carrier substrate* and a *chip* are mutually defined as substrates of relatively larger and smaller size, respectively, so that a plurality of chips can be attached to a carrier substrate. For the sake of convenience of expression (e.g., where used in combination with a chip), a carrier substrate may simply be referred to as a substrate.

An *integrated circuit* is a miniaturized electrical circuit which is supported by a substrate.

In the Figures, for the sake of clarity, chips and substrate are shown enlarged as compared with typical embodiments; also, proportions in the Figures may not be as typically used in practice. To the extent not further specified below, choice of actual dimensions and proportions will be a matter of course in actual practice.

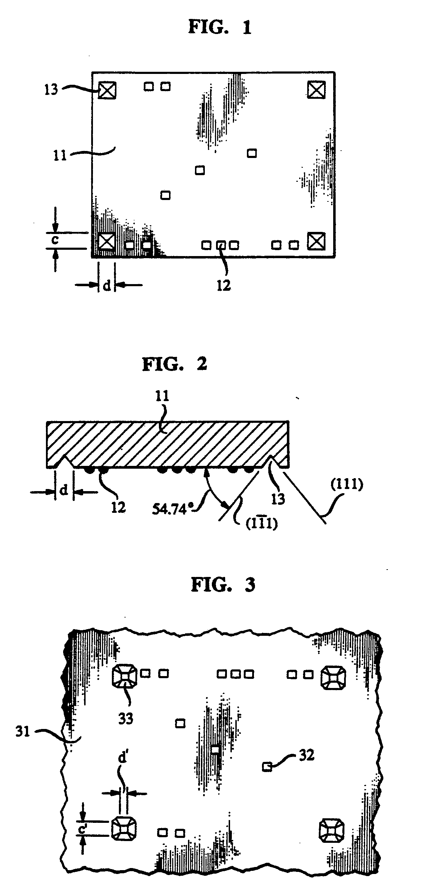

FIG. 1 and 2 show integrated circuit chip 11, solder pads 12 on the active side of chip 11, and depressions 13 etched into the surface of chip 11 in the form of inverted pyramids.

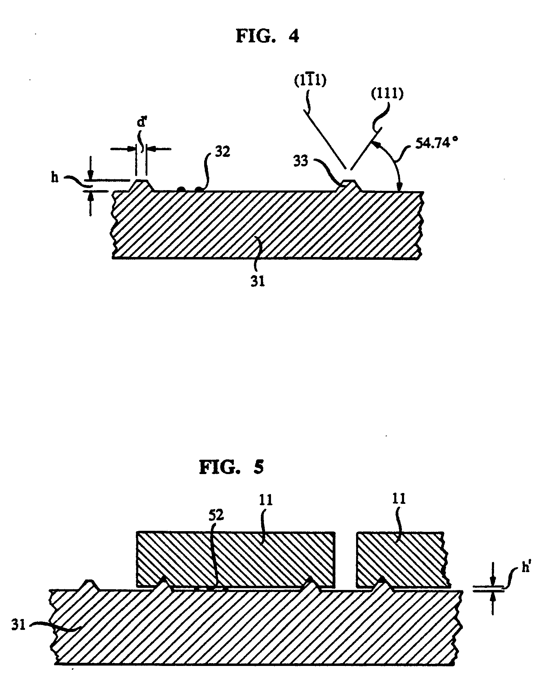

FIG. 3 and 4 show carrier substrate 31, solder pads 32 on carrier substrate 31, and pyramids 33 as obtained by surface etching of carrier substrate 31 in the presence of a suitable mask.

FIG. 5 shows substrate 31 and integrated circuit chips 11 as described above in further detail in connection with FIG. 1-4, solder pads 12 and 32 having coalesced into solder connections 52 as effected by heating.

Surface features such as, e.g., pyramids 33 and matching inverted pyramids 13 may be produced by orientation-dependent (anisotropic) chemical etching; e.g., a (100)-silicon surface may be etched in this fashion by means of a solution of 20 percent potassium hydroxide in water and in the presence of selectively applied oxide, nitride, or metal material serving as a surface mask. (This example is of considerable importance as silicon integrated circuit devices, bipolar as well as metal oxide-semiconductor, are customarily manufactured on (100)-oriented silicon.) In this case, the potassium hydroxide etching solution attacks silicon the slowest along the (111)-axis, thereby permitting, e.g., the formation of pyramids having (111)-surfaces aligned along <110> directions of oxide mask edges on the (100)-wafer. The dimensions $c$ and $d$ (see FIG. 1 and 2), and the location of the pyramids are defined with lithographic precision. As illustrated by intersecting (111)-planes in FIG. 2, etching of surface depressions is self-terminating as a function of the mask dimensions and the $54.74°$ angle between the (111) and (100) silicon planes.

FIG. 3 shows a mating counterpart on a silicon (100)-wafer. Again, matching pyramids may be obtained by orientation-depending etching in the presence of masks which cover the (flat) tops of the pyramids. Depending on the details of etching, the sloping edges of the pyramids will be rounded - without impairment of match-up with etched depressions 13. The dimensions of the pyramids are defined by those of the mask which preferably is chosen such that $c'$ is less than $c$, and $d'$ less than $d$ (see FIG. 3 and 4). And again, the location and dimensions of the pyramids are defined with lithographic precision, and their height $h$ (see FIG. 4) is determined by the rate and duration of etching. For example, an aqueous, 20-percent potassium hydroxide solution at a temperature of $90°C$ etches (100)-silicon at a rate of approximately 2 micrometers/min. Control of the height $h$ is readily to within ±1 micrometer - a small tolerance as compared with typical total solder stand-off of approximately 20 micrometers or more. With similar precision the device chips can be matched to the silicon substrate (see FIG. 5, where the gap $h'$ is less than the height $h$ of the pyramids), resulting in close control of solder collapse as is desirable in the interest of preventing solder run-off and attendant device impairment.

Power dissipated in the integrated-circuit chips can be removed either from the back side of the chips or else from their active side through the solder connections into a cooled substrate. In the latter case, the tight control of $h'$ provided by the alignment pyramids assures well-controlled, reliable heat paths.

It is observed that etching inverted pyramids into chips in the presence of a mask leaves the chip surface used for device fabrication untouched. While the corresponding surface of the substrate is etched, such surface was found to be smooth and free of defects, with a roughness of less than approximately 200 nanometers.

While orientation-dependent chemical etching is considered as particularly suitable as applied to single-crystal silicon or Group III-V compound semiconductors, other fabrication techniques may be used as applied to these or alternate substrate and chip materials. Included among such techniques are not only ablation methods such as, e.g., milling and etching, but also pressing, stamping coining and other forms of surface deforming where applicable. Furthermore, the shape of alignment features is not limited to that of pyramids but includes, e.g., prismatic (straight-walled) and rounded features. Prismatic features can be produced e.g., by ion milling, and convex and concave hemispherical features by photochemical etching.

While, in the example as described above and is depicted in the Figures, corresponding surface features having essentially conforming or mating (pyramid) shape, such conformance is not essential. For example, in this respect, prismatic features on one surface may readily match up with pyramid-shaped features on the other, and the same applied to other combinations of shapes.

The following are considered as particularly significant advantages of chip alignment on a substrate in accordance with the invention:

(i) positive chip-to-wafer spacing is realized independent of the size and consistency of solder connections;

(ii) for electrical contacting via solder pads, direct access is possible to any desired interior point on a chip surface, making it unnecessary for conductors to terminate in solder pads placed along the perimeter of a chip;

(iii) metallizations on chips and substrate can remain limited to level surfaces, and no steps, gaps, or slopes need be traversed; and

(iv) where matching chip- and substrate-surface features are used, positive alignment can be achieved with respect to the other coordinates - linear as well as angular - between chip and substrate, in addition to chip-to-wafer spacing.

## Claims

1. An assembly comprising a substrate (31) and an integrated-circuit chip (11), a surface of said chip, here designated as first surface, facing a corresponding portion of a surface of said substrate, here designated as second surface, said first surface comprising first contacts (12) and said second surface comprising second contacts (32), said assembly comprising means (52) for electrical interconnection across a desired distance between said first contacts and said second contacts, CHARACTERIZED IN THAT at least said first or said second surface further comprises surface features (13, 33) in physical contact with the facing surface, whereby said desired distance is essentially realized.

2. The assembly of claim 1, wherein said means for electrical interconnection comprising solder.

3. The assembly of claim 1, wherein said surface features are in contact with corresponding surface features on said facing surface.

4. The assembly of claim 3, wherein said surface features are essentially mating surface features.

5. The assembly of claim 1, wherein said substrate and said chip substantially consist of single-crystal silicon.

6. The assembly of claim 5, wherein said first surface and said silicon surface are substantially (100)-surfaces.

7. The assembly of claim 6, wherein said surface features substantially have the shape of pyramids.

## FIG. 1

## FIG. 2

## FIG. 3

FIG. 4

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 25, no. 4, September 1982, pages 2094-2095, New York, US; H.R. BICKFORD et al.: "Silicon-to-silicon part alignment system" | 1-7 | H 01 L 21/60<br>H 01 L 23/14<br>H 01 L 29/06 |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 27-12-1988 | DE RAEVE R.A.L. |